# EUROPEAN PATENT APPLICATION

(11) **EP 4 608 113 A1**
(43) Date of publication of application: **27.08.2025**
(21) Application number: 25158974.3
(22) Date of filing: 19.02.2025
(51) Int. Cl.: H10K 71/12, H10K 85/50, H10K 71/40

(54) **A DEVICE AND A METHOD FOR PRODUCING THIN FILMS ON A SUBSTRATE**

(30) Priority: 21.02.2024 PL 44782624
(71) Applicant: Uniwersytet Jagiellonski, 31-007 Krakow (PL)
(72) Inventor: DABCZYNSKI, Pawel, 26-130 Suchedniow (PL); AWSIUK, Kamil, 30-394 Krakow (PL); ZEMLA, Joanna, 31-922 Krakow (PL); RYSZ, Jakub, 32-070 Czernichow (PL); BUDKOWSKI, Andrzej, 31-214 Krakow (PL); BUCKA, Katarzyna, 32-100 Proszowice (PL)
(74) Representative: Kancelaria Eupatent.pl Sp. z.o.o

(57) **Abstract**

A device for producing thin films on a substrate, the device comprising: a first head (110) configured to deposit a thin film solution (20) onto a substrate (10) movable relative to said first head (110); and a second head (120) configured to dispense, in an inert carrier gas, process-agent vapors (30) onto the thin film solution (20) applied to the substrate (10), wherein the second head (120) is positioned at a distance (X) from the first head (110) such that said process-agent vapors (30) are introduced at a predetermined stage of solvent evaporation of the thin film solution (20).

## Description

### TECHNICAL FIELD

This invention relates to a device and method for producing thin films on a substrate. In particular, it concerns a system for applying and modifying layers by controlling the properties of the liquid precursor, allowing for improved uniformity and film quality.

### BACKGROUND

Various devices and methods for producing thin films on substrates are known in the art, including spray coating techniques and meniscus-based methods. By way of example, devices and processes using the meniscus-stretching approach are disclosed in patent publications WO2019110456A1, WO2019179794A1, and WO2019185357A1. In particular, WO2019179794A1 describes a system comprising a platform for supporting a substrate, a guiding element that moves relative to the platform to stretch a liquid into a meniscus on the substrate, and an associated activation system for inducing an electrochemical reaction in the liquid within the meniscus.

A common challenge in fabricating organic and inorganic thin films is preserving adequate stability of the precursor solutions. One known strategy involves adding coordinating solvents to precisely control the films' physicochemical properties. However, such an approach can severely reduce the stability of the precursor solutions, often resulting in premature precipitation of the film-forming material. This problem is highlighted in Li, J. et al., "20.8% Slot-Die Coated MAPbI3 Perovskite Solar Cells by Optimal DMSO-Content and Age of 2-ME Based Precursor Inks" (Adv. Energy Mater. 11, (2021)), where a mixture of 2-methoxyethanol and dimethyl sulfoxide was employed to form the perovskite precursor solution. Notably, in that slot-die coating system, an air or nitrogen jet dispensing source was used.

### SUMMARY

There is a need to provide a device and method to enable precise control over the physicochemical properties of thin films during their formation.
The present invention addresses this need by introducing a universal approach, referred to herein as vapor-modified gas quenching, in which process vapors (such as solvents, antisolvents, or strongly coordinating agents) are delivered in the vapor phase onto a forming/partially formed layer. Crucially, this avoids adding such agents directly to the precursor solution, which would otherwise destabilize it (e.g., by causing immediate precipitation in the case of antisolvents, or reducing temporal stability when highly coordinating compounds are used). Consequently, the temporal stability of the precursor solution is preserved, while uniform distribution of the process agent over the entire film-forming area is ensured. This strategy is particularly advantageous for forming perovskite layers, but can be applied broadly to any wet-deposited thin film system requiring controlled tuning of its physicochemical properties.

In one aspect, the invention is related to a device for producing thin films on a substrate, the device comprising: a first head configured to deposit a thin film solution onto a substrate movable relative to said first head; and a second head configured to dispense, in an inert carrier gas, process-agent vapors onto the thin film solution applied to the substrate. The second head is positioned at a distance from the first head such that said process-agent vapors are introduced at a predetermined stage of solvent evaporation of the thin film solution. This allows precise control over the physicochemical properties of the forming film by delivering the process agent at an optimal point in the drying phase.

In a preferred embodiment, the first head is adapted to dispense the thin film solution via a meniscus-stretching method on the substrate. Therefore, it is possible to achieve uniform coating across the substrate, leading to better control over film thickness and morphology.

In a further preferred embodiment, the device comprises a carrier-gas delivery system having at least two flow paths: a first flow path passing through a container with the liquid form of the process agent, thereby picking up its vapors, and a second flow path bypassing said container, wherein each flow path is controlled by a flow meter, allowing adjustment of the ratio between process-agent-laden carrier gas and pure carrier gas. Such a configuration provides fine-tuning of the partial vapor pressure of the process agent, enhancing flexibility and precision in controlling film properties.

In yet another preferred embodiment, the distance between the first head and the second head is adjustable so as to optimize the timing of vapor introduction relative to the drying stage of the thin film solution. This allows adaptation to different solution chemistries and substrate speeds, ensuring process versatility.

In another preferred embodiment, the device further comprises a movement mechanism configured to control the speed at which the substrate traverses relative to the first head and the second head, thereby coordinating the coating operation and the introduction of the process-agent vapors. Hence, stable and repeatable process conditions are maintained for improved film uniformity and reproducibility.

In a still further preferred embodiment, the second head comprises at least one elongated slot or nozzle adapted to distribute the process-agent vapors uniformly across at least a portion of the substrate. Such design ensures even delivery of vapors and, consequently, uniform film quality over the substrate area.

In another aspect, the present inveniton is related to a method of producing thin films on a substrate using the device described above, the method comprising: depositing the thin film solution onto the substrate via the first head; and dispensing the process-agent vapors, carried by an inert gas, from the second head onto the partially dried thin film solution to modify its physicochemical properties. This allows the formation of high-quality thin films by controlling the vapor introduction at the most effective stage of the drying process.

In a preferred embodiment of the method, the process-agent vapors comprise at least one of: a solvent or a mixture of solvents, a counter-solvent or a mixture of counter-solvents, or one or more coordinating agents. Therefore, it is possible to tailor the method to the requirements of diverse film materials and desired characteristics.

In a further preferred embodiment of the method, the partial pressure of the process agent is controlled by adjusting the ratio of the first flow path to the second flow path. Such control provides granular tuning of the concentration of the vapors, optimizing film morphology and crystallization rates.

In another preferred embodiment of the method, the distance between the first head and the second head is chosen such that a predetermined amount of the solvent from the thin film solution evaporates before the process-agent vapors contact the deposited layer. Thus, the drying kinetics can be effectively regulated, leading to improved final film microstructure.

In an additional preferred embodiment of the method, the thin film solution comprises a perovskite precursor containing at least one organic or inorganic cation source and at least one metal halide. This allows the method to be readily applied to fabricating high-efficiency perovskite thin films for optoelectronic applications.

In a further preferred embodiment, the perovskite precursor is adapted to form a methylammonium lead halide perovskite such as MAPbI₃, MAPbI₃₋ₓClₓ, or another mixed-halide or mixed A-site cation perovskite. Hence, stable and highly crystalline perovskite layers can be achieved for enhanced device performance.

In yet another preferred embodiment, the inert gas is nitrogen or argon. Such inert conditions minimize unwanted side reactions and contamination, improving overall film quality.

In an additional preferred embodiment, the method further comprises thermally annealing the thin film after the introduction of the process-agent vapors to improve crystal growth and/or phase formation. Therefore, it is possible to enhance crystal structure and device performance through a post-deposition heat treatment.

In a still further preferred embodiment, the thin film is configured for use in an optoelectronic device selected from the group consisting of photovoltaic cells, photodiodes, light-emitting diodes (LEDs), and photodetectors. Thus, the device and method provide a highly versatile solution for manufacturing thin films in a wide range of applications.

These and other features, aspects and advantages of the invention will become better understood with reference to the following drawings, descriptions and claims.

### BRIEF DESCRIPTION OF DRAWINGS

The invention is shown by means of example embodiment on a drawing, wherein:
Fig. 1 is a schematic illustration of an example device according to the invention, showing the first head that applies the thin film solution and the second head that dispenses process vapors.
Fig. 2 is a plot of the absorbance for the first embodiment, compared against a reference sample.
Fig. 3 is a plot of the absorbance for the second embodiment, compared against a reference sample.
Fig. 4 is a plot of the absorbance for the third embodiment, compared against a reference sample.
Fig. 5 is a plot of the absorbance for the fourth embodiment, compared against a reference sample.
Fig. 6a presents diffractograms of layers obtained in the fifth embodiment, for different process agents used during vapor-modified gas quenching.
Fig. 7 shows the Raman spectra for the sixth embodiment, comparing samples produced according to the invention both before and after annealing, as well as a reference sample.

### DETAILED DESCRIPTION

Below, exemplary embodiments of the invention are described in detail with reference to the accompanying drawings. The figures and embodiments are provided to illustrate various aspects and should not be viewed as limiting the scope of the invention.

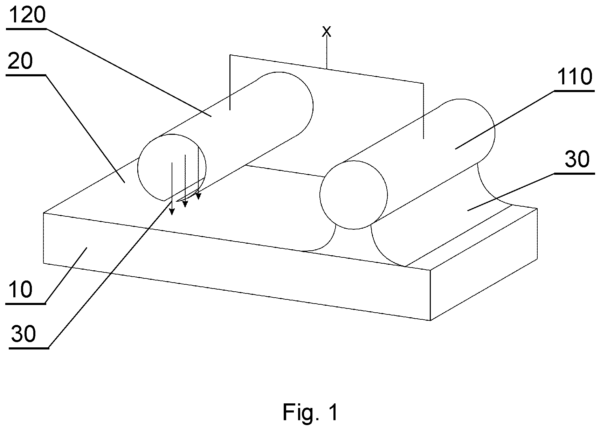

Referring to Fig. 1, the method according to the invention is carried out using a device that includes a first head 110 for applying a thin film solution 20 onto a substrate 10, and a second head 120 for dispensing process vapors 30. The overall structure of the device may adopt various forms known in the art. In one example, it is based on systems that stretch a liquid meniscus across a substrate, as disclosed in WO2019110456A1, WO2019179794A1, and WO2019185357A1. In such an arrangement, the first head 110 can have a configuration suitable for forming and stretching the meniscus 40 containing the solution 20 onto the substrate 10.

Movement between the first head 110 and the substrate 10 can be achieved in different ways. For instance, the first head 110 may be mounted on a mobile assembly that traverses above a stationary substrate 10, or conversely, the substrate 10 may move while the first head 110 remains stationary. Alternatively, both the first head 110 and the substrate 10 can move in opposing directions or at variable speeds. The particular mechanism by which the thin film solution 20 is applied is not critical to the essence of the invention. By way of non-limiting illustration, in Fig. 1, the first head 110 is shown in a cylindrical form that stretches the solution from a meniscus 40 across the substrate 10, which travels in the direction indicated by the arrow.

Positioned at a certain distance X from the first head 110 is the second head 120, which dispenses process vapors 30 onto the thin film solution 20 recently applied to the substrate 10. This distance X is selected experimentally to ensure that the process vapors 30 are introduced at the proper stage of solvent evaporation or "initial drying" of the precursor solution 20. The optimal distance X may differ depending on the composition of the solution 20 and is determined on a case-by-case basis.

The second head 120 delivers the process vapors 30 using a carrier gas. The structure of the second head 120 can be of any known type, such as a cylindrical body with a longitudinal slot, a broad oval nozzle, or an air-knife-style nozzle. In some embodiments, the first head 110 and the second head 120 may be mounted on movable gantries, allowing the operator to adjust the distance X according to the processing requirements and the desired properties of the final film.

Two carrier gas flow paths are provided within the system:
- a first flow path in which the carrier gas passes through a Dreschel bottle containing the liquid form of the process agent, picking up its vapors;
- a second flow path in which pure carrier gas bypasses the Drechsel bottle, thereby remaining free of the process agent.

The two flows are combined downstream, and the proportion of process-agent-laden gas to pure carrier gas is controlled by digital flow meters. This allows precise regulation of the ratio of process vapors to carrier gas in the final flow exiting the second head 120.

The following parameters can be important for implementing the method according to the invention:
- Choice of process agent: This agent modifies the physicochemical properties of the final thin film without altering the precursor solution itself. It may be selected from a solvent (or solvent mixture), a strongly coordinating compound, a counter-solvent, or combinations thereof.
- Flow ratio: The ratio of the carrier gas that passes through the liquid process agent (first flow path) to the carrier gas that bypasses the process agent (second flow path) directly affects the partial vapor pressure and concentration of the dispensed agent.
- Partial vapor pressure: The partial pressure of the process-agent vapors in the carrier gas should be tuned to achieve the desired interaction with the forming film.
- Total gas flow: The overall flow rate of the carrier gas (sum of both paths) is typically optimized experimentally.
- Relative movement speed: The velocity at which the substrate 10 moves relative to the two heads 110 and 120 is chosen experimentally, depending on the precursor solution composition (20) and the chosen process agent (30).
- Distance X: The separation between the first head 110 and the second head 120 is established experimentally so that the process agent is delivered to the thin film solution 20 at the most effective stage of pre-drying. This depends on the substrate speed and the chemical properties of the precursor solution 20.
- Chemical identity of the agent: The process agent (or agents) introduced in vapor form strongly influences the resulting film structure; hence the choice of agent is a key variable.

Although the method will be illustrated through various embodiments focusing on perovskite thin films, it should be noted that the inventive approach is equally applicable to any thin film produced by wet methods where a vapor-phase agent can alter the final structure. Examples include polymeric layers, oxide layers, or metallic layers. For instance, if a Tollens solution were used as the precursor solution 20 and formic acid or an aldehyde derivative were introduced as the process agent 30, metallic silver would form on the substrate surface.

In a preferred embodiment, the second head (120) can be rigidly mounted on the same frame or gantry as the first head (110), such that the motion of the substrate (10) carries the newly deposited film beneath the second head (120). The distance X between the first head (110) and the second head (120) is typically in the range of 5-50 mm, more preferably 9-39 mm, as exemplified in the embodiments. This distance ensures that the thin film solution (20) has partially dried (i.e., some fraction of the solvent has evaporated) before contacting the process-agent vapors (30). A skilled person will appreciate that the optimal XXX depends on substrate speed, solvent volatility, ambient humidity, and the desired interaction time with the vapors.

The second head (120) preferably comprises a longitudinal slot nozzle spanning the width of the substrate (10) to ensure uniform delivery of the process-agent vapors (30). The nozzle is positioned approximately 1-10 mm above the substrate surface, but this height can be varied according to the viscosity of the precursor solution and the vapor concentration. The nozzle geometry (e.g., rectangular slot or circular holes in a manifold) is not critical, as long as it permits a uniform distribution of vapors.

The device includes a carrier-gas delivery system having at least two flow paths: (i) a first path that routes inert gas (e.g., nitrogen) through a container (such as a Dreschel bottle) holding the liquid form of the process agent, and (ii) a second path that bypasses that container. Flow meters or mass-flow controllers regulate each path so that one can set, for example, a total flow of 1000-5000 sccm and a desired process-agent-vapor concentration between 0 vol.% and 50 vol.% (or higher). Typical process agents include toluene, chlorobenzene, 2-propanol, DMSO, or mixtures thereof.

### Comparative Example - MAPbI₃₀

A perovskite precursor solution 20 comprising methylammonium iodide (MAI), lead(II) iodide (PbI₂), and 2-methoxyethanol (2-ME) was prepared in a 1 M concentration with a 1:1 molar ratio of MAI to PbI₂. This solution was then applied to an indium tin oxide (ITO)-coated glass substrate 10 using the stretched-meniscus method. The process parameters included an acceleration of 20 mm/s² and a coating speed of 2 mm/s. In this comparative example, vapor-modified gas quenching was not employed (i.e., no second head 120 was used). The ambient relative humidity was 26.3%.

### First Embodiment - MAPbI₃₁

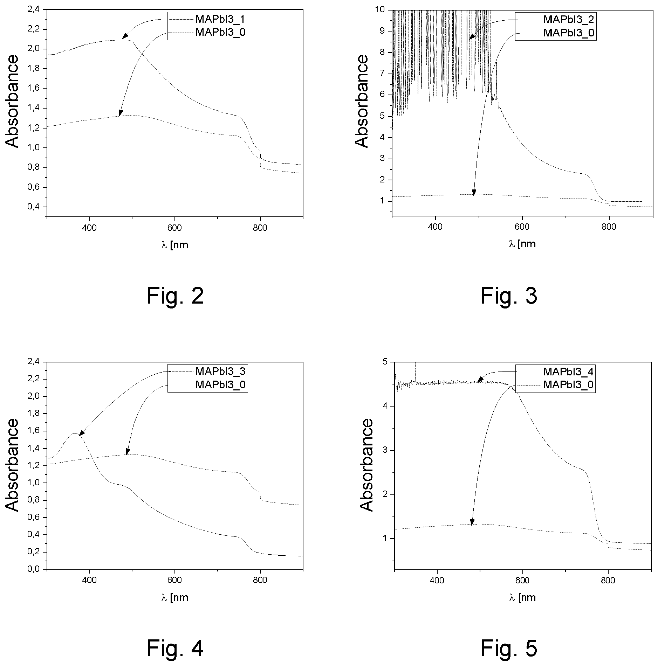

A 1 M perovskite precursor solution 20 of MAI and PbI₂ (1:1 molar ratio) in 2-ME was deposited onto an ITO-coated glass substrate 10 with the stretched-meniscus method (acceleration: 20 mm/s²; speed: 2 mm/s). In this embodiment, the second head 120 provided vapor-modified gas quenching using toluene as the process agent. Nitrogen was the carrier gas, flowing at 4000 scc/min with a toluene:nitrogen ratio of 1:3. The distance X between the first head 110 and the second head 120 was 9.5 mm, and ambient relative humidity was 26.3%. Fig. 2 presents absorbance measurements of the resulting film compared to a reference.

### Second Embodiment - MAPbI₃₂

A 1 M perovskite precursor solution of MAI and PbI₂ (1:1) in 2-ME was applied with the stretched-meniscus method, using an acceleration of 20 mm/s² and a coating speed of 10 mm/s. The second head 120 supplied chlorobenzene vapors to induce vapor-modified gas quenching. Nitrogen was again used as the carrier gas, at a total flow of 4000 scc/min, with a chlorobenzene:nitrogen ratio of 1:0 (i.e., carrier gas did not bypass the solvent bottle, ensuring high vapor concentration). The distance X was 16 mm, and the ambient relative humidity was 49%. Fig. 3 shows the absorbance curve compared to a reference.

### Third Embodiment - MAPbI₃₃

A 1 M solution of MAI and PbI₂ in 2-ME was deposited at 20 mm/s² acceleration and 10 mm/s coating speed. Vapor-modified gas quenching employed 2-propanol vapors carried by nitrogen at 4000 scc/min, using a 1:1 ratio of 2-propanol vapor to pure nitrogen. The distance X was 39 mm, and ambient relative humidity was 49%. Fig. 4 provides absorbance data compared to a reference.

### Fourth Embodiment - MAPbI₃₄

A 1 M solution of MAI and PbI₂ in 2-ME was coated under the same meniscus-stretching conditions (20 mm/s² acceleration; 10 mm/s coating speed). However, the second head 120 delivered 2-propanol vapors in a 1:3 ratio with pure nitrogen (total flow 4000 scc/min). The distance X was 39 mm, and ambient humidity was 49%. Fig. 5 shows the resulting absorbance curve compared to a reference.

In the first, second, and fourth embodiments, the films produced according to the invention exhibited higher absorbance than the corresponding reference samples, suggesting improved film quality that may translate into enhanced solar cell performance. In the third embodiment, the absorbance was also improved but to a lesser degree, indicating that the method of the invention allows selective control over the formation of certain phases or domains within the film.

### Fifth Embodiment - MAPbICl

A commercially available "Perovskite Precursor Ink for Air Processing" from Ossila (I101) was used, containing methylammonium lead iodide and lead chloride in a 3:1 molar ratio. The precursor ink 20 was applied using the stretched-meniscus method with an acceleration of 20 mm/s² and a speed of 10 mm/s. Two distinct processes were performed for vapor-modified gas quenching: one using 2-propanol and another using DMSO. Nitrogen served as the carrier gas, at a total flow of 4000 scc/min, with a process-agent-to-nitrogen ratio of 1:1. The distance X was 9.5 mm, and the ambient relative humidity was 20%.

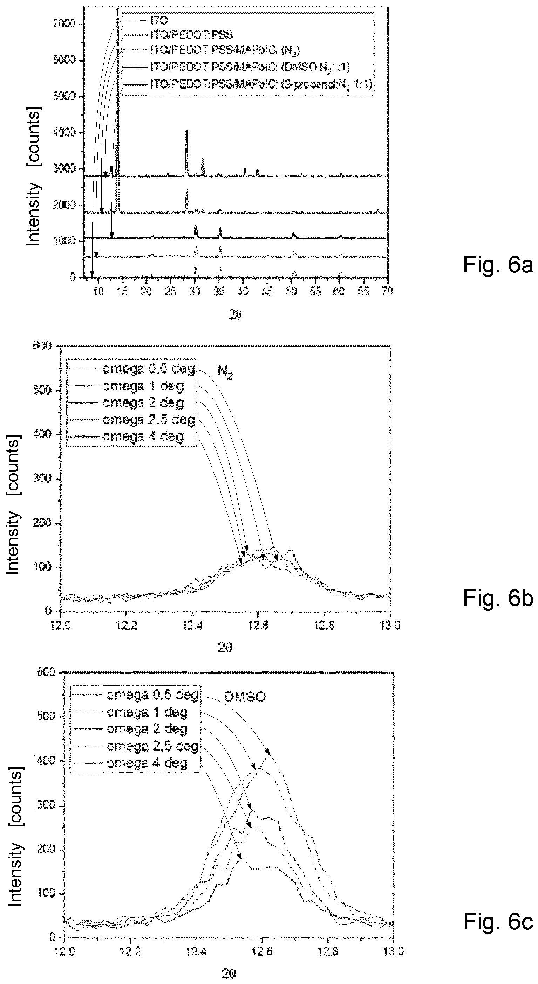

Fig. 6a presents X-ray diffractograms (at a 1.5° incidence angle) of:
- the bare ITO substrate,
- the ITO/PEDOT:PSS substrate,
- an ITO/PEDOT:PSS/MAPbICI layer subjected to vapor-modified gas quenching with pure nitrogen,
- an ITO/PEDOT:PSS/MAPbICl layer subjected to gas quenching with a DMSO-nitrogen mixture at 1:1 ratio,
- an ITO/PEDOT:PSS/MAPbICl layer subjected to gas quenching with a 2-propanol-nitrogen mixture at 1:1 ratio.

Figs. 6b and 6c show the corresponding diffractograms for the region associated with the (001) reflection of hexagonal PbI₂, measured as a function of incidence angle for (b) the reference system and (c) the system processed with DMSO vapors.

These diffractograms demonstrate a notable difference in crystal structure when gas quenching with either 2-propanol or DMSO. Furthermore, the depth-dependent measurements shown in Figs. 6b and 6c indicate that the perovskite's crystalline structure can be selectively tuned at various sampling depths, another level of control enabled by the present method.

### Sixth Embodiment - MAPbI₃₅

A 1 M solution of MAI and PbI₂ (1:1) in 2-ME was applied using the stretched-meniscus method at 20 mm/s² acceleration and 2 mm/s coating speed. For vapor-modified gas quenching, DMSO was introduced via nitrogen at 4000 scc/min, with a DMSO:nitrogen ratio of 1:0 (i.e., no pure carrier gas bypass). The distance X between the first head 110 and the second head 120 was 39 mm, the ambient relative humidity was 25%, and the resulting film underwent annealing at 120 °C for 10 minutes.

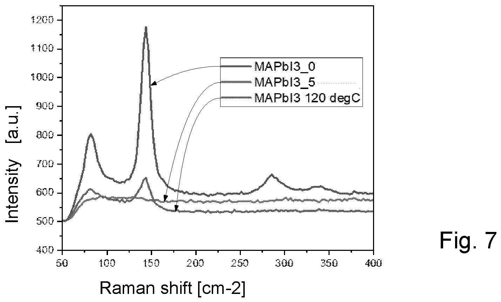

Fig. 7 depicts Raman spectra of the MAPbI₃₅ samples before and after annealing, alongside the comparative MAPbI₃₀ film. These spectra focus on the regions associated with PbO signals [see W.O. Herrera Martinez et al., "Effect of high energy proton irradiation on MAPbI3 films for space applications observed by micro-Raman spectroscopy," Mater Adv 1 (2020) 2068-2073]. The air-heated film produced with DMSO vapors shows a significantly lower PbO content, highlighting that PbO formation here is a parasitic side reaction rather than a desired component of the film.

Overall, these embodiments illustrate that controlling the introduction of process-agent vapors, be they solvents, counter-solvents, strongly coordinating compounds, or mixtures thereof, enables fine-tuning of the thin film's properties without prematurely destabilizing the precursor solution. By selectively varying parameters such as carrier gas flow rates, vapor partial pressures, and the distance X between the heads, the final film's morphology, crystal phase distribution, and other key characteristics can be optimized for applications such as photovoltaic devices.

While the invention has been described with respect to a limited number of embodiments, it will be appreciated that many variations, modifications and other applications of the invention may be made. Therefore, the claimed invention as recited in the claims that follow is not limited to the embodiments described herein.

## Claims

1. A device for producing thin films on a substrate, the device comprising:
- a first head (110) configured to deposit a thin film solution (20) onto a substrate (10) movable relative to said first head (110); and
- a second head (120) configured to dispense, in an inert carrier gas, process-agent vapors (30) onto the thin film solution (20) applied to the substrate (10),
- wherein the second head (120) is positioned at a distance (X) from the first head (110) such that said process-agent vapors (30) are introduced at a predetermined stage of solvent evaporation of the thin film solution (20).

2. The device of claim 1, wherein the first head (110) is adapted to dispense the thin film solution (20) via a meniscus-stretching method on the substrate (10).

3. The device of claim 1 or 2, further comprising a carrier-gas delivery system having at least two flow paths: a first flow path passing through a container with the liquid form of the process agent, thereby picking up its vapors and a second flow path bypassing said container, wherein each flow path is controlled by a flow meter, allowing adjustment of the ratio between process-agent-laden carrier gas and pure carrier gas.

4. The device of any one of claims 1 to 3, wherein the distance (X) between the first head (110) and the second head (120) is adjustable so as to optimize the timing of vapor introduction relative to the drying stage of the thin film solution (20).

5. The device of any one of claims 1 to 4, further comprising a movement mechanism configured to control the speed at which the substrate (10) traverses relative to the first head (110) and the second head (120), thereby coordinating the coating operation and the introduction of the process-agent vapors (30).

6. The device of any one of claims 1 to 5, wherein the second head (120) comprises at least one elongated slot or nozzle adapted to distribute the process-agent vapors (30) uniformly across at least a portion of the substrate (10).

7. A method of producing thin films on a substrate (10) using a device according to any one of claims 1 to 6, the method comprising:
- depositing the thin film solution (20) onto the substrate (10) via the first head (110); and
- dispensing the process-agent vapors (30), carried by an inert gas, from the second head (120) onto the partially dried thin film solution (20) to modify its physicochemical properties.

8. The method of claim 7, wherein the process-agent vapors (30) comprise at least one of:
- a solvent or a mixture of solvents,
- a counter-solvent or a mixture of counter-solvents,
- one or more coordinating agents.

9. The method of any one of claims 7 to 8, further comprising controlling the partial pressure of the process agent by adjusting the ratio of the first flow path to the second flow path.

10. The method of any one of claims 7 to 9, wherein the distance (X) between the first head (110) and the second head (120) is chosen such that a predetermined amount of solvent from the thin film solution (20) evaporates before the process-agent vapors (30) contact the deposited layer.

11. The method of any one of claims 7 to 10, wherein the thin film solution (20) comprises a perovskite precursor containing at least one organic or inorganic cation source and at least one metal halide.

12. The method of claim 11, wherein the perovskite precursor is adapted to form a methylammonium lead halide perovskite such as MAPbI₃, MAPbI₃₋ₓClₓ, or another mixed-halide or mixed A-site cation perovskite.

13. The method of any one of claims 7 to 12, wherein the inert gas is nitrogen or argon.

14. The method of any one of claims 7 to 13, further comprising thermally annealing the thin film after the introduction of the process-agent vapors (30) to improve crystal growth and/or phase formation.

15. The method of any one of claims 7 to 14, wherein the thin film is configured for use in an optoelectronic device selected from the group consisting of photovoltaic cells, photodiodes, light-emitting diodes (LEDs), and photodetectors.
